# EUROPEAN PATENT APPLICATION

(11) **EP 3 709 352 A1**
(43) Date of publication of application: **16.09.2020**
(21) Application number: 20152511.0
(22) Date of filing: 17.01.2020
(51) Int. Cl.: H01L 23/498, H05K 1/02, H05K 1/11

(54) **CERAMIC SUBSTRATE**

(30) Priority: 11.03.2019 JP 2019043645
(71) Applicant: Hitachi Metals, Ltd., Minato-ku Tokyo 108-8224 (JP)
(72) Inventor: TANIE, Hisashi, Tokyo, 100-8280 (JP); HAYASHI, Kenji, Tokyo, 108-8224 (JP); SHIMAZU, Hiromi, Tokyo, 100-8280 (JP)
(74) Representative: MERH-IP Matias Erny Reichl Hoffmann Patentanwälte PartG mbB

(57) **Abstract**

A ceramic substrate 10 capable of suppressing the reduced reliability caused by via 14 misalignment during manufacturing, and capable of suppressing the reduced reliability caused by thermal stress between the ceramic substrate 10 and a mounting board 30 is provided. The ceramic substrate 10 includes an electrode and a via 14 connected to the electrode. The ceramic substrate 10 includes a plurality of vias 14 provided to a center portion in a first direction of the electrode along a second direction. The first direction is parallel to a surface on which the electrode is disposed. The first direction is a direction connecting a center of the surface to a center of the electrode. The second direction is parallel to the surface and perpendicular to the first direction.

## Description

### BACKGROUND

### Technical Field

The present disclosure relates to a ceramic substrate.

### Background Art

Conventionally, there has been known a disclosure relating to a multilayer ceramic substrate formed by laminating and firing ceramic green sheets having required vias and metal film wiring patterns, and the multilayer ceramic substrate includes the wiring patterns on a surface layer and an inner layer (see JP 2009-239100 A). This conventional multilayer ceramic substrate includes circular recessed portions, electrodes, solder materials, and metal balls (see JP 2009-239100 A, claim 1 and the like). The circular recessed portion has at least two or more concentric steps on a bottom surface of the ceramic substrate. The electrodes are disposed on bottom surfaces of the respective stages of the recessed portion. The solder materials are filled in the recessed portion and joined to the electrodes. The metal ball is joined to the solder materials.

With this conventional multilayer ceramic substrate, by forming the circular recessed portion having the at least two or more concentric steps on the bottom surface of the ceramic substrate to provide a step structure inside the recessed portion, the number of depressed corner portions increases. This ensures dispersing thermal stress, which is caused by a difference in coefficient of thermal expansion between a mounting board and the ceramic substrate and concentrated to the corner portion, in many directions to significantly reduce the thermal stress applied on one portion. Accordingly, crack generation at the recessed portion of a terminal connecting portion disposed on the bottom surface of the ceramic substrate can be effectively reduced and suppressed, and a mounting strength of the multilayer ceramic substrate can be enhanced, thus ensuring the enhanced reliability (see JP 2009-239100 A, paragraph 0008 and the like).

### SUMMARY

Low Temperature Co-fired Ceramics (LTCC) substrate such as the conventional multilayer ceramic substrate is manufactured by laminating and sintering a plurality of ceramic green sheets as described above. Such a ceramic substrate requires redundancy such that even when via positions of the respective layers are displaced to some extent due to dimensional change of the ceramic layers during sintering, the vias of the respective layers are connected to ensure connection reliability of the electrodes on front and back sides of the substrate. However, it is difficult to provide such redundancy to the conventional multilayer ceramic substrate because of its structure.

As described above, since the conventional multilayer ceramic substrate has the step structure inside the recessed portion of the bottom surface of the ceramic substrate, the number of depressed corner portions can be increased, thus dispersing to reduce the thermal stress concentrated to the corner portions in many directions. However, the thermal stress caused by the difference in coefficient of thermal expansion between the mounting board and the ceramic substrate differs depending on the position on the bottom surface of the ceramic substrate and the temperature change of the ceramic substrate. Therefore, simply increasing the number of depressed corner portions possibly causes disconnection at a part of terminal connecting portion to reduce reliability of the ceramic substrate because of the position on the bottom surface of the ceramic substrate and the temperature change of the ceramic substrate and the mounting board.

The disclosure provides a ceramic substrate capable of suppressing the reduced reliability caused by via misalignment during manufacturing, and capable of suppressing the reduced reliability caused by thermal stress between the ceramic substrate and a mounting board.

An aspect of the disclosure is a ceramic substrate that includes an electrode and a via connected to the electrode. A plurality of the vias are provided to a center portion in a first direction of the electrode along a second direction. The first direction is parallel to a surface on which the electrode is disposed. The first direction is a direction connecting a center of the surface to a center of the electrode. The second direction is parallel to the surface and perpendicular to the first direction.

The aspect of the disclosure can provide the ceramic substrate capable of suppressing the reduced reliability caused by via misalignment during manufacturing, and capable of suppressing the reduced reliability caused by thermal stress between the ceramic substrate and a mounting board.

### BRIEF DESCRIPTION OF THE DRAWINGS

FIG. 1A is a front view of a ceramic substrate according to Embodiment 1 of the disclosure;
FIG. 1B is a bottom view of the ceramic substrate of FIG. 1A;
FIG. 1C is a cross-sectional view taken along the line C-C of the ceramic substrate of FIG. 1B;
FIG. 2A is a front view illustrating an example of use of the ceramic substrate of FIG. 1A;
FIG. 2B is a front view illustrating an example of use of the ceramic substrate of FIG. 1A;
FIG. 3 is a perspective view describing a method for manufacturing the ceramic substrate of FIG. 1A;
FIG. 4 is an enlarged cross-sectional view of a ceramic substrate according to a comparative configuration;
FIG. 5 is an enlarged cross-sectional view of the ceramic substrate of FIG. 1A;
FIG. 6A is a front view of the ceramic substrate and the mounting board illustrated in FIG. 2A before thermal distortion;
FIG. 6B is a front view of the ceramic substrate and the mounting board illustrated in FIG. 2A after thermal distortion;
FIG. 7 is a bottom view illustrating regions where thermal stresses acting on electrodes of the ceramic substrate are large;
FIG. 8 is a bottom view of a ceramic substrate according to Embodiment 2 of the disclosure;
FIG. 9 is a bottom view of a ceramic substrate according to Embodiment 3 of the disclosure;
FIG. 10 is a bottom view of a ceramic substrate according to Embodiment 4 of the disclosure;
FIG. 11 is a bottom view of a ceramic substrate according to Embodiment 5 of the disclosure;
FIG. 12 is a bottom view of a ceramic substrate according to Embodiment 6 of the disclosure;
FIG. 13A is a cross-sectional view of a ceramic substrate according to Embodiment 7 of the disclosure;
FIG. 13B is a bottom view of the ceramic substrate of FIG. 13A;
FIG. 13C is a cross-sectional view taken along the line C-C of the ceramic substrate of FIG. 13B;
FIG. 14A is a bottom view illustrating a via arrangement of the ceramic substrate according to an example of the disclosure;
FIG. 14B is a principal stress distribution map of the ceramic substrate according to the example illustrated in FIG. 14A;
FIG. 15A is a bottom view illustrating a via arrangement of a ceramic substrate according to a comparative example;
FIG. 15B is a principal stress distribution map of the ceramic substrate according to the comparative example illustrated in FIG. 15A; and
FIG. 16 is a graph indicating maximum principal stresses of the ceramic substrates of the example and the comparative example.

### DETAILED DESCRIPTION

The following describes the embodiments of the ceramic substrate according to the disclosure with reference to the drawings.

### (Embodiment 1)

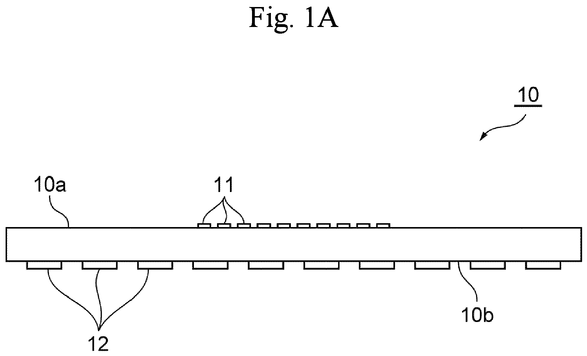

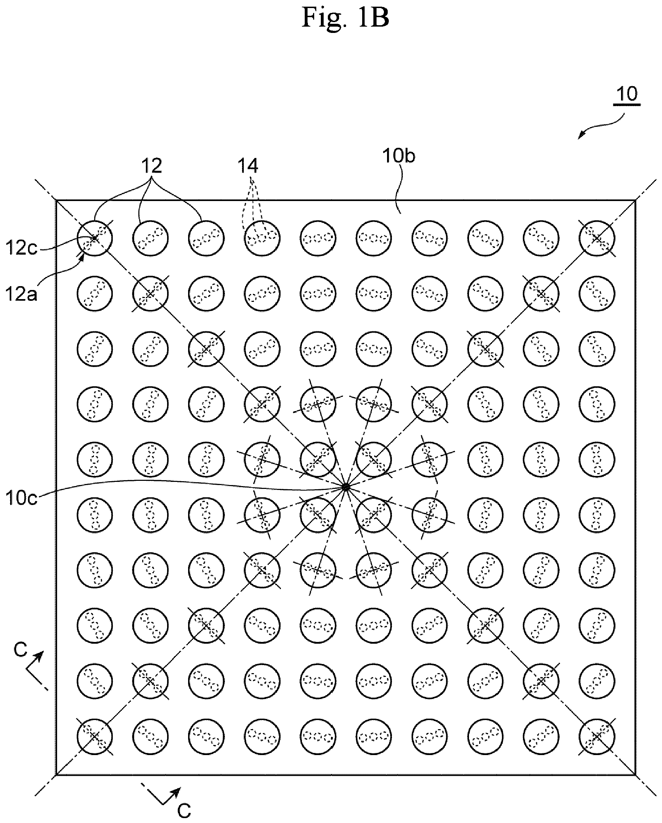

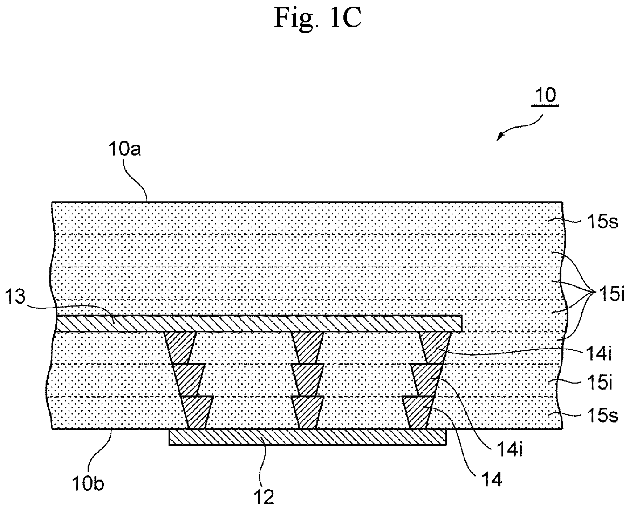

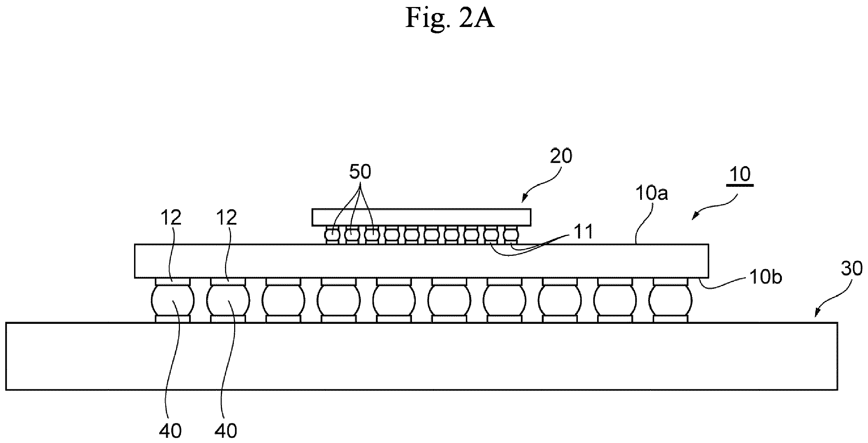

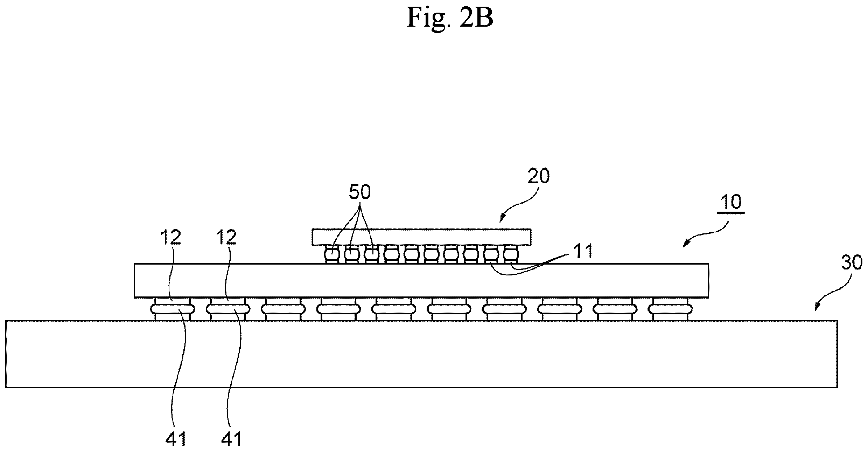

FIG. 1A is a front view of a ceramic substrate 10 according to Embodiment 1 of the disclosure. FIG. 1B is a bottom view of the ceramic substrate 10 of FIG. 1A. FIG. 1C is a cross-sectional view taken along the line C-C of the ceramic substrate 10 of FIG. 1B. FIG. 2A and FIG. 2B are each a front view illustrating an example of use of the ceramic substrate 10 of FIG. 1A.

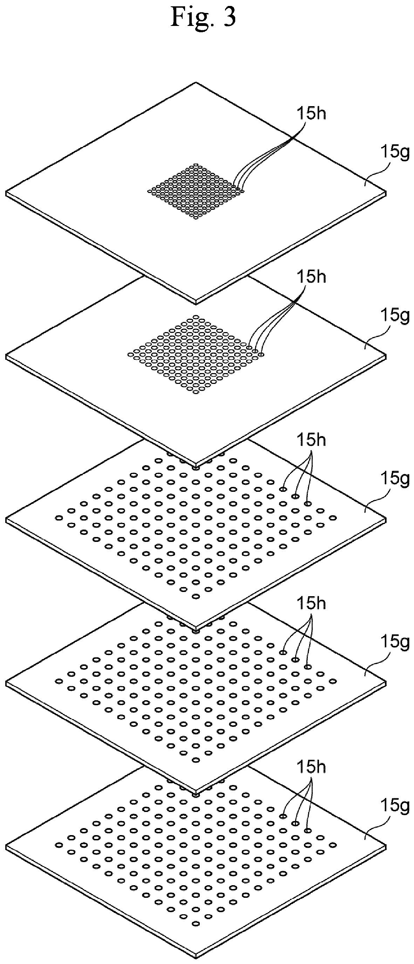

A material of the ceramic substrate 10 is a ceramic. Therefore, the ceramic substrate 10 is excellent in heat resistance and moisture resistance, and is low in loss. The ceramic substrate 10 is, for example a Low Temperature Co-fired Ceramics (LTCC) substrate. The LTCC can have a sintering temperature of a ceramic green sheet 15g (see FIG. 3) at, for example, about 1000°C. Therefore, the use of silver or copper, which has a low melting point, for an inner layer wiring 13, a via 14, and an inner layer via 14i of the ceramic substrate 10 is allowed to achieve a circuit having a low electrical resistance.

As illustrated in FIG. 2A and FIG. 2B, the ceramic substrate 10 of the embodiment is disposed, for example, between a semiconductor element 20 and a mounting board 30 having different terminal pitches, and is used as an interposer that relays a terminal of the semiconductor element 20 and a terminal of the mounting board 30. The semiconductor element 20 is, for example, a semiconductor chip containing silicon as the main component. The mounting board 30 is, for example, a printed wiring board having a main body of a glass epoxy and including copper wiring. The ceramic substrate 10 of the embodiment mainly has the following configuration.

The ceramic substrate 10 includes electrodes 12 and the via 14 connected to the electrodes 12. The ceramic substrate 10 includes a plurality of vias 14 along a second direction at a center portion 12a in a first direction of the electrode 12, and the first direction is parallel to a surface 10b on which the electrode 12 is disposed. The first direction is a direction connecting a center 10c of the surface 10b, on which the electrodes 12 are disposed, of the ceramic substrate 10 to a center 12c of the electrode 12, and the second direction is a direction parallel to the surface 10b, on which the electrodes 12 are disposed, of the ceramic substrate 10 and perpendicular to the first direction. The following describes the configuration of the ceramic substrate 10 of the embodiment in more detail.

The ceramic substrate 10 includes, for example, a plurality of electrodes 12 on one surface 10b as illustrated in FIG. 1B. The plurality of vias 14 are provided along the second direction of each electrode 12 on the center portion 12a in the first direction of each electrode 12. In FIG. 1B, for the plurality of electrodes 12 disposed on diagonal lines of the ceramic substrate 10 and the plurality of electrodes 12 disposed in the center portion of the ceramic substrate 10, the first directions of the respective electrodes 12 are indicated by one-dot chain lines, and the second directions of the respective electrodes 12 are indicated by two-dot chain lines. For the other electrodes 12, the illustrations of the first directions and the second directions are omitted.

Here, the center portion 12a in the first direction of each electrode 12 is a portion, for example, passing through the center of the electrode 12 in the first direction, including a point on a straight line parallel to the second direction of that electrode 12, and having a predetermined width on both sides of the straight line. The width in the first direction of the center portion 12a of the electrode 12 is, for example, 1/2 or less of the full-width of the electrode 12 in the first direction, and is preferably 1/3 or less of the full-width or more preferably 1/4 or less of the full-width in some embodiments.

The ceramic substrate 10 includes, for example, a plurality of primary side electrodes 11 connected to the semiconductor element 20 on a surface 10a on the opposite side of the surface 10b on which the plurality of electrodes 12 are disposed as illustrated in FIG. 1A, FIG. 2A and FIG. 2B. That is, the plurality of electrodes 12 disposed on the one surface 10b of the ceramic substrate 10 illustrated in FIG. 1B are secondary side electrodes, for example, disposed in a wide range compared with the plurality of primary side electrodes 11 with wide pitches compared with the plurality of primary side electrodes 11 and connected to the mounting board 30 illustrated in FIG. 2A and FIG. 2B.

The ceramic substrate 10 has, for example, a layered structure or a multilayer structure in which a plurality of ceramic layers 15s and 15i are layered as illustrated in FIG. 1C. For example, the ceramic layer 15s on the surface 10b side on which the electrodes 12 as the secondary side electrodes are disposed includes the plurality of vias 14 connected to those electrodes 12. The ceramic layer 15i inside the ceramic layer 15s on the surface 10b side includes a plurality of inner layer vias 14i. In the second direction as a right-left direction of the cross section of FIG. 1C, the plurality of inner layer vias 14i provided to the ceramic layer 15i inside the ceramic layer 15s on the surface 10b side are provided at intervals different from those of the vias 14 on the surface 10b side connected to the electrodes 12 as the secondary side electrodes. These plurality of inner layer vias 14i are at least partially connected to the vias 14 on the surface 10b side.

More specifically, for example, the interval and the pitch of the plurality of vias 14 provided to the ceramic layer 15s on the surface 10b side are different from the interval and the pitch of the plurality of inner layer vias 14i provided to the ceramic layer 15i inside the ceramic layer 15s on the surface 10b side. Furthermore, the interval and the pitch of the plurality of inner layer vias 14i provided to the ceramic layer 15i inside the ceramic layer 15s on the surface 10b side are different from the interval and the pitch of the plurality of inner layer vias 14i provided to the ceramic layer 15i further inside the ceramic layer 15i. In addition, the plurality of inner layer vias 14i of each ceramic layer 15i are at least partially connected to the plurality of vias 14 of the ceramic layer 15s on the surface 10b side.

Accordingly, the respective primary side electrodes 11 are connected to the respective electrodes 12 as the secondary side electrodes via at least a part of the plurality of vias 14 and at least a part of the plurality of inner layer vias 14i. In more detail, in the example illustrated in FIG. 1B and FIG. 1C, the three vias 14 provided along the second direction are connected to each of the electrodes 12 as the secondary side electrodes disposed on the one surface 10b of the ceramic substrate 10. However, the number of vias 14 provided along the second direction only needs to be two or more, and may be four or more.

The electrodes 12 as the secondary side electrodes of the ceramic substrate 10 are each connected to the inner layer wiring 13 via, for example, the vias 14 provided to the ceramic layer 15s on the surface 10b side, the inner layer vias 14i provided to the ceramic layer 15i inside the ceramic layer 15s on the surface 10b side, and the inner layer vias 14i provided to the ceramic layer 15i further inside that ceramic layer 15i. However, the number of the ceramic layers 15s and 15i between each electrode 12 and the inner layer wiring 13 is not specifically limited.

The primary side electrodes 11 are connected to the respective electrodes 12 as the secondary side electrodes via, for example, the inner layer wiring 13 and other plurality of inner layer vias and vias not illustrated in FIG. 1C in addition to the plurality of vias 14 and the plurality of inner layer vias 14i. The inner layer wiring 13 and the other plurality of inner layer vias not illustrated in FIG. 1C are provided to the inner ceramic layer 15i. The other plurality of vias not illustrated in FIG. 1C are provided to the ceramic layer 15s on the surface 10a side on which the primary side electrodes 11 are disposed, and connected to the primary side electrodes 11 and the other inner layer vias. For the material of the via 14, the inner layer via 14i, and the inner layer wiring 13, for example, silver that can be sintered with the ceramic green sheet at the temperature of 1000°C or less is usable.

Thus, an electric circuit is formed inside the ceramic substrate 10 having the multilayer structure such that the plurality of primary side electrodes 11 are connected to the plurality of electrodes 12 as the secondary side electrodes via the vias 14, the inner layer vias 14i, the inner layer wiring 13, and the like. The ceramic substrate 10 can include the circuit with wiring layers having different scales on the surface 10a on which the primary side electrodes 11 are disposed and the surface 10b on which the electrodes 12 as the secondary side electrodes are disposed. Therefore, the ceramic substrate 10 can be used as, for example, a substrate for a high frequency module and a semiconductor package.

The ceramic substrate 10 includes the plurality of electrodes 12 arranged, for example, as illustrated in FIG. 1B, at predetermined intervals in each of a third direction and a fourth direction that are parallel to the surface 10b on which the electrodes 12 are disposed and mutually orthogonal. In other words, in the example illustrated in FIG. 1B, the plurality of electrodes 12 of the ceramic substrate 10 are disposed on intersection points of a grid formed by a plurality of straight lines arranged parallel to the third direction at regular intervals and a plurality of straight lines arranged parallel to the fourth direction at regular intervals. In the example illustrated in FIG. 1B, the third direction and the fourth direction are a direction along one side edge and a direction along the other side edge of mutually orthogonal longitudinal and lateral side edges of the rectangular ceramic substrate 10.

More specifically, in the example illustrated in FIG. 1B, the ceramic substrate 10 has a roughly square outer shape. The plurality of electrodes 12 as the secondary side electrodes disposed on the surface 10b of the ceramic substrate 10 have roughly circular outer shapes. Ten electrodes 12 are disposed in the third direction along the longitudinal side edge of the ceramic substrate 10, ten electrodes 12 are disposed in the fourth direction along the lateral side edge of the ceramic substrate 10, and thus, one hundred electrodes 12 in total are disposed in an array of 10 × 10 longitudinally and laterally.

That is, for example, as illustrated in FIG. 2A, the ceramic substrate 10 has a Ball Grid Array (BGA) structure, where solder balls 40 containing tin as the main component are arranged in a grid pattern, to connect the plurality of electrodes 12 as the secondary side electrodes to the mounting board 30. The connection of the ceramic substrate 10 to the mounting board 30 is not limited to the connection by the BGA structure, but for example, as illustrated in FIG. 2B, may be a connection via thin solder layers 41. The connection of the ceramic substrate 10 to the mounting board 30 is not limited to the connection via the solder balls 40 or the thin solder layers 41, but may be a connection via an anisotropic conductive film or a sintered material.

For example, as illustrated in FIG. 2A and FIG. 2B, the ceramic substrate 10 includes solder balls 50 containing tin as the main component to connect the plurality of primary side electrodes 11 to the semiconductor element 20. The electrodes of the semiconductor element 20 have dimensions and pitches different from dimensions and pitches of the electrodes of the mounting board 30. Specifically, for example, the dimensions and the pitches of the electrodes of the semiconductor element 20 are smaller than the dimensions and the pitches of the electrodes of the mounting board 30. However, disposing the ceramic substrate 10 as an interposer between the semiconductor element 20 and the mounting board 30 ensures connecting the electrodes of the semiconductor element 20 to the electrodes of the mounting board 30 having different scales to form an electric and electronic circuit.

Next, with reference to FIG. 3 to FIG. 5, actions in manufacturing the ceramic substrate 10 of the embodiment will be described. FIG. 3 is a perspective view describing a method for manufacturing the ceramic substrate 10 of FIG. 1A.

The ceramic substrate 10 can be manufactured by, for example, laminating and sintering a plurality of ceramic green sheets 15g. For example, the ceramic green sheets 15g are each provided with through holes 15h for forming the vias 14 and the inner layer vias 14i before the lamination, and a paste material containing silver is arranged inside the through holes 15h. Here, the pitch of the through holes 15h of the ceramic green sheet 15g close to the primary side electrode 11 is formed smaller than, for example, the pitch of the through holes 15h of the ceramic green sheet 15g close to the electrode 12 as the secondary side electrode.

Thus, the ceramic substrate 10 illustrated in FIG. 1A to FIG. 1C can be manufactured by laminating and sintering the plurality of ceramic green sheets 15g where the paste material is disposed on the through holes 15h and wiring patterns and electrode patterns are formed of the material on a part of the surface. The number of the ceramic green sheets 15g to be laminated is not specifically limited, but may be appropriately changed depending on the circuit to be formed.

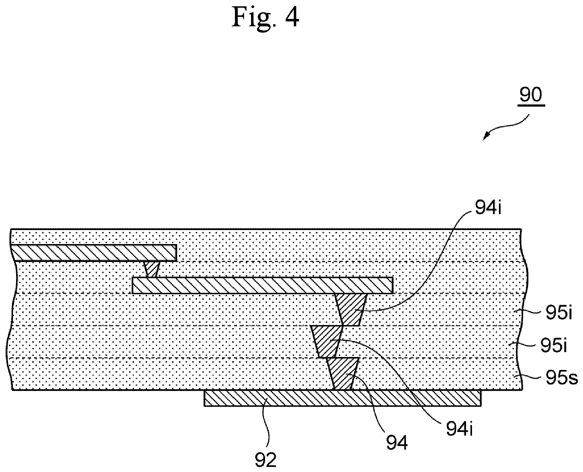

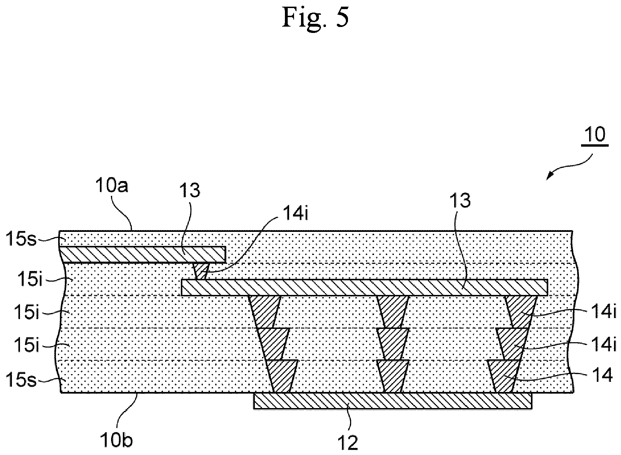

FIG. 4 is an enlarged cross-sectional view of a ceramic substrate 90 according to a comparative configuration different from the ceramic substrate 10 of the embodiment. FIG. 5 is an enlarged cross-sectional view of the ceramic substrate 10 of FIG. 1A. When the ceramic layers 15s and 15i are formed by sintering the ceramic green sheet 15g, the dimensions of the ceramic layers 15s and 15i after sintering slightly change from the dimension of the ceramic green sheet 15g before sintering.

Due to such dimensional change, as illustrated in FIG. 4, a misalignment occurs in some cases between the positions of one via 94 connected to an electrode 92 and one inner layer via 94i provided to a ceramic layer 95i inside the via 94. In this case, in the ceramic substrate 90 according to the comparative configuration, the electrical connection of the one via 94 of a ceramic layer 95s to the one inner layer via 94i of the ceramic layer 95i is possibly cut off to cause the reduced reliability of the ceramic substrate 90.

In contrast, the ceramic substrate 10 of the embodiment includes the electrode 12 and the via 14 connected to the electrode 12 as described above, and is configured as follows. The ceramic substrate 10 includes the plurality of vias 14 on the center portion 12a in the first direction of the electrode 12 along the second direction, the first direction is parallel to the surface 10b on which the electrode 12 is disposed, the first direction is a direction connecting the center 10c of the surface 10b to the center 12c of the electrode 12, and the second direction is parallel to the surface 10b and perpendicular to the first direction.

With this configuration, the plurality of vias 14 illustrated in FIG. 5 can be at least partially connected to the plurality of inner layer vias 14i adjacent to those plurality of vias 14 with more certainty compared with the connection of the one via 94 of the ceramic layer 95s to the one inner layer via 94i of the ceramic layer 95i illustrated in FIG. 4. More specifically, even when the misalignment occurs between the positions of the plurality of vias 14 connected to the electrodes 12 and the plurality of inner layer vias 14i provided to the ceramic layer 15i on the inner side of those plurality of vias 14, the plurality of vias 14 can be at least partially connected to the plurality of inner layer vias 14i with higher probability.

This ensures the improved connection reliability between the vias 14 connected to the electrode 12 and the inner layer vias 14i connected to these vias 14. Accordingly, the ceramic substrate 10 of the embodiment can more reliably connect these vias 14 to the inner layer vias 14i even when the misalignment of the positions of the vias 14 of the ceramic layer 15s or the inner layer vias 14i of the ceramic layer 15i occurs to some extent due to the dimensional change of the ceramic layer 15s or 15i during sintering. That is, the embodiment can provide the ceramic substrate 10 that has redundancy to ensure the connection reliability even when the misalignment of the position of the via 14 or the inner layer via 14i occurs to some extent as described above, and the ceramic substrate 10 capable of suppressing the reduced reliability caused by the misalignment of the via 14 during manufacturing.

Similarly, the inner layer vias 14i connected to the vias 14 can be at least partially connected to the plurality of inner layer vias 14i provided to the ceramic layer 15i inside the inner layer vias 14i connected to the vias 14 with higher probability. Furthermore, the plurality of inner layer vias 14i provided to this ceramic layer 15i can be connected to the inner layer wiring 13 adjacent to these inner layer vias 14i with higher probability. Accordingly, the ceramic substrate 10 of the embodiment can provide the more improved connection reliability between the primary side electrode 11 and the electrode 12 as the secondary side electrode.

The ceramic substrate 10 of the embodiment has the multilayer structure where the plurality of ceramic layers 15s and 15i are laminated as described above. The plurality of inner layer vias 14i are provided to the ceramic layer 15i inside the ceramic layer 15s on the surface 10b side where the vias 14 are provided. In addition, in the second direction, the plurality of inner layer vias 14i are provided at intervals different from those of the plurality of vias 14 on the surface 10b side, and at least partially connected to the vias 14 on the surface 10b side.

With this configuration, at least a part of the plurality of vias 14 provided to the ceramic layer 15s on the surface 10b side can be more reliably connected to at least a part of the plurality of inner layer vias 14i provided to the ceramic layer 15i inside the plurality of vias 14. Specifically, assume that the misalignment occurs between the position of any of the inner layer vias 14i provided to the ceramic layer 15i inside the ceramic layer 15s on the surface 10b side and the position of the via 14 provided to the ceramic layer 15s on the surface 10b side, and they are disconnected. Even in this case, the other via 14 can be connected to the inner layer via 14i.

That is, when the pitch of the plurality of vias 14 is equal to the pitch of the plurality of inner layer vias 14i, the disconnection between the one via 14 and the one inner layer via 14i due to the misalignment similarly causes the disconnections between the other vias 14 and the inner layer vias 14i due to the misalignment. However, since the pitch of the plurality of vias 14 is different from the pitch of the plurality of inner layer vias 14i, even when the connection of any of the vias 14 to any of the inner layer vias 14i is cut off due to the misalignment, the positions of the other via 14 and the inner layer via 14i can be aligned to establish the connection. Accordingly, the ceramic substrate 10 of the embodiment can provide the more improved connection reliability between the primary side electrode 11 and the electrode 12 as the secondary side electrode.

For example, when a distortion amount and a distortion direction of each ceramic green sheet 15g are predictable, the positions and the intervals of the plurality of vias 14 and the positions and the intervals of the plurality of inner layer vias 14i can be set depending on the distortion amount and the distortion direction. This configuration can deal with the larger misalignment between the via 14 and the inner layer via 14i compared with the case where the positions and the intervals of the plurality of vias 14 are arbitrarily differed from the positions and the intervals of the plurality of inner layer vias 14i.

The ceramic substrate 10 of the embodiment includes the plurality of primary side electrodes 11, which are connected to the semiconductor element 20, on the surface 10a on the opposite side of the surface 10b on which the electrodes 12 are disposed. The plurality of electrodes 12 are secondary side electrodes disposed in a wide range compared with the plurality of primary side electrodes 11 and connected to the mounting board 30. The primary side electrodes 11 are connected to the respective electrodes 12 as the secondary side electrodes via at least a part of the plurality of vias 14 and at least a part of the plurality of inner layer vias 14i.

With this configuration, the ceramic substrate 10 is disposed between the semiconductor element 20 and the mounting board 30 which are different in terminal pitch, to ensure relaying between the electrode of the semiconductor element 20 connected to the primary side electrode 11 and the electrode of the mounting board 30 connected to the electrode 12 as the secondary side electrode. Accordingly, the use of the ceramic substrate 10 as the interposer ensures connecting the electrodes of the semiconductor element 20 to the electrodes of the mounting board 30 having different scales to form an electric and electronic circuit.

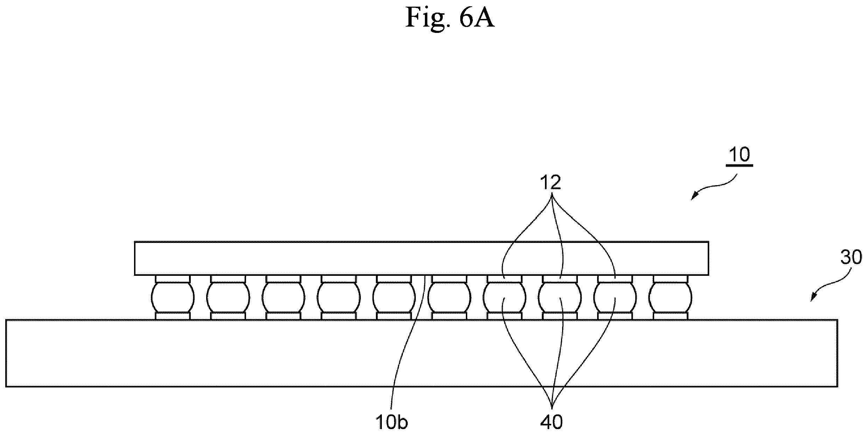

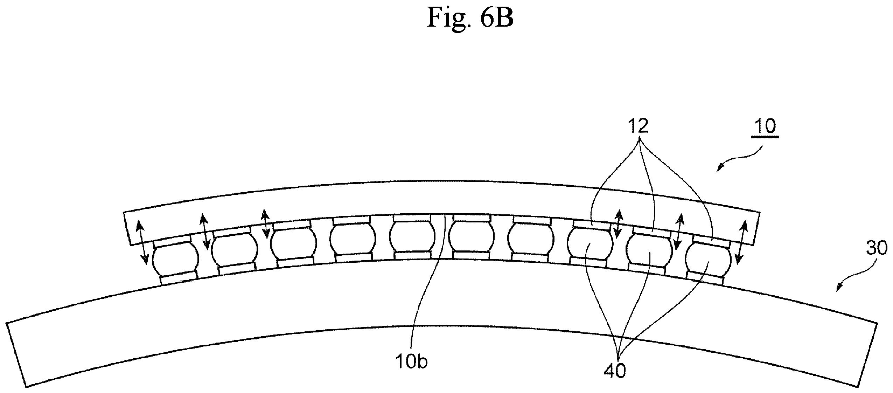

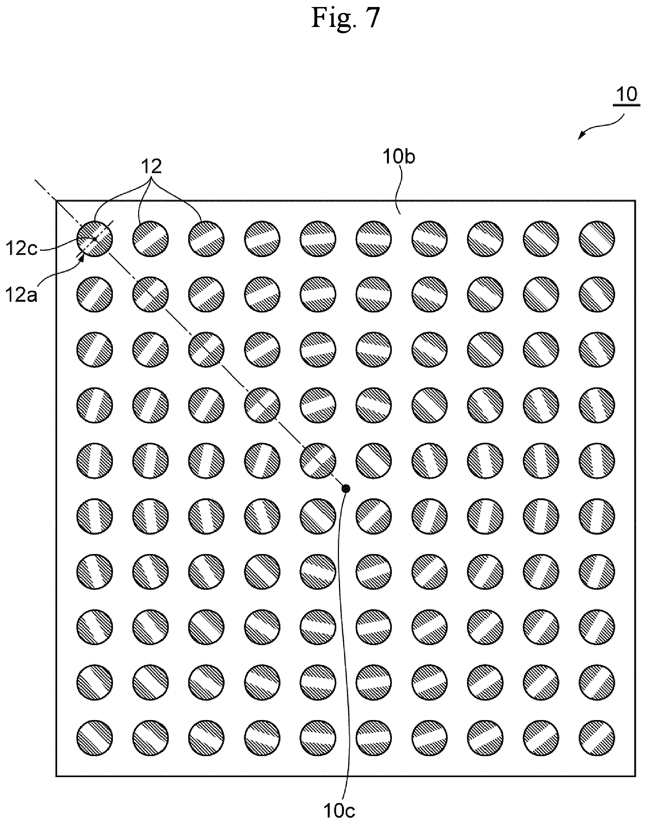

Next, with reference to FIG. 6A, FIG. 6B, and FIG. 7, actions of the ceramic substrate 10 of the embodiment mounted to the mounting board 30 will be described.

FIG. 6A is a front view of the ceramic substrate 10 and the mounting board 30 illustrated in FIG. 2A before thermal distortion. FIG. 6B is a front view of the ceramic substrate 10 and the mounting board 30 illustrated in FIG. 2A after thermal distortion. In FIG. 6A and FIG. 6B, the illustrations of the primary side electrodes 11, the solder balls 50, and the semiconductor element 20 of the ceramic substrate 10 illustrated in FIG. 2A are omitted.

The ceramic constituting the ceramic substrate 10 has a linear expansion coefficient, for example, smaller than a linear expansion coefficient of the glass epoxy constituting the mounting board 30. Accordingly, the decrease of the temperatures of the ceramic substrate 10 and the mounting board 30 from the state before thermal distortion illustrated in FIG. 6A causes a shrinkage of the mounting board 30 larger than a shrinkage of the ceramic substrate 10. Therefore, on the surface of the mounting board 30 on which the ceramic substrate 10 is mounted, the ceramic substrate 10 suppresses the shrink of the mounting board 30.

Consequently, as illustrated in FIG. 6B, a curve is provided to the mounting board 30 such that the mounting board 30 is convexly curved toward the ceramic substrate 10. At this time, a tensile force acts on the electrodes 12 of the ceramic substrate 10 from the mounting board 30 via the solder balls 40. This tensile force causes a thermal stress peeling the electrodes 12 off the surface 10b of the ceramic substrate 10 to act on the electrodes 12.

The increase of the temperatures of the ceramic substrate 10 and the mounting board 30 from the state before thermal distortion illustrated in FIG. 6A causes an expansion amount of the mounting board 30 larger than an expansion amount of the ceramic substrate 10. Therefore, on the surface of the mounting board 30 on which the ceramic substrate 10 is mounted, the ceramic substrate 10 suppresses the expansion of the mounting board 30.

Consequently, contrary to the curved direction illustrated in FIG. 6B, a curve is provided to the mounting board 30 such that the mounting board 30 is convexly curved toward the opposite side of the ceramic substrate 10. At this time, a pushing force acts on the electrodes 12 of the ceramic substrate 10 from the mounting board 30 via the solder balls 40. This pushing force causes a thermal stress peeling the electrodes 12 off the surface 10b of the ceramic substrate 10 to act on the electrodes 12.

FIG. 7 is a bottom view of the ceramic substrate 10 illustrating regions where the thermal stresses acting on the electrodes 12 of the ceramic substrate 10 become large during the temperature decrease and during the temperature increase of the ceramic substrate 10 and the mounting board 30. In FIG. 7, for each electrode 12, on the center portion 12a in the first direction without hatching, the thermal stress acting during the temperature decrease and during the temperature increase of the ceramic substrate 10 and the mounting board 30 is relatively small compared with the other portions.

However, for each electrode 12, on the hatched region on the outer edge side of the ceramic substrate 10 with respect to the center portion 12a, the thermal stress becomes relatively large compared with the other portions during the temperature decrease of the ceramic substrate 10 and the mounting board 30. For each electrode 12, on the hatched region on the center 10c side of the ceramic substrate 10 with respect to the center portion 12a, the thermal stress becomes relatively large compared with the other portions during the temperature increase of the ceramic substrate 10 and the mounting board 30.

Here, the ceramic substrate 10 of the embodiment includes the electrode 12 and the via 14 connected to the electrode 12 as described above. As illustrated in FIG. 1B, the ceramic substrate 10 includes the plurality of vias 14 on the center portion 12a in the first direction of the electrode 12 along the second direction, the first direction is parallel to the surface 10b on which the electrode 12 is disposed, the first direction is a direction connecting the center 10c of the surface 10b to the center 12c of the electrode 12, and the second direction is parallel to the surface 10b and perpendicular to the first direction.

With this configuration, the plurality of vias 14 illustrated in FIG. 1B and FIG. 1C can be provided to the center portion 12a of the electrode 12 where the thermal stress acting on the electrode 12 is relatively small compared with the other portions. This ensures the reduced stress acting between the electrode 12 and the via 14 during the temperature decrease and during the temperature increase of the ceramic substrate 10 and the mounting board 30 compared with the case where the via 14 is connected to the portion other than the center portion 12a of the electrode 12. Therefore, the disconnection between the electrode 12 and the via 14 due to the thermal stress acting on the electrode 12 is suppressed to improve the connection reliability between the electrode 12 and the via 14. Accordingly, the embodiment can provide the ceramic substrate 10 capable of suppressing the reduced reliability caused by the thermal stress between the ceramic substrate 10 and the mounting board 30.

The ceramic substrate 10 of the embodiment includes the plurality of electrodes 12 on the surface 10b as described above. In addition, the plurality of vias 14 are provided to the center portion 12a in the first direction of each electrode 12 along the second direction of each electrode 12.

With this configuration, as illustrated in FIG. 7, the plurality of vias 14 can be provided to the center portion 12a in the first direction where the thermal stress is smaller than that of the other portions for every electrode 12 provided to the surface 10b of the ceramic substrate 10. Accordingly, the ceramic substrate 10 of the embodiment capable of improving the connection reliability between the electrode 12 and the via 14 for every electrode 12 of the ceramic substrate 10, and capable of suppressing the reduced reliability caused by the thermal stress between the ceramic substrate 10 and the mounting board 30.

The ceramic substrate 10 of the embodiment includes the plurality of electrodes 12 arranged at predetermined intervals in each of the third direction and the fourth direction that are parallel to the surface 10b and mutually orthogonal as described above. That is, in the ceramic substrate 10 of the embodiment, the plurality of electrodes 12 are disposed on the intersection points of the plurality of straight lines parallel to the third direction and the plurality of straight lines parallel to the fourth direction.

With this configuration, as illustrated in FIG. 2A, the ceramic substrate 10 has the BGA structure, where the solder balls 40 containing tin as the main component are arranged in a grid pattern, to ensure connecting the plurality of electrodes 12 as the secondary side electrodes to the mounting board 30. Employing the BGA structure eliminates the need for disposing an electrode projecting to an outer periphery of the ceramic substrate 10, thus ensuring the reduced mounting area of the ceramic substrate 10 for the mounting board 30.

As described above, the embodiment can provide the ceramic substrate 10 capable of suppressing the reduced reliability caused by the misalignment between the vias 14 and the inner layer vias 14i during manufacturing, and capable of suppressing the reduced reliability caused by the thermal stress between the ceramic substrate 10 and the mounting board 30.

### (Embodiment 2)

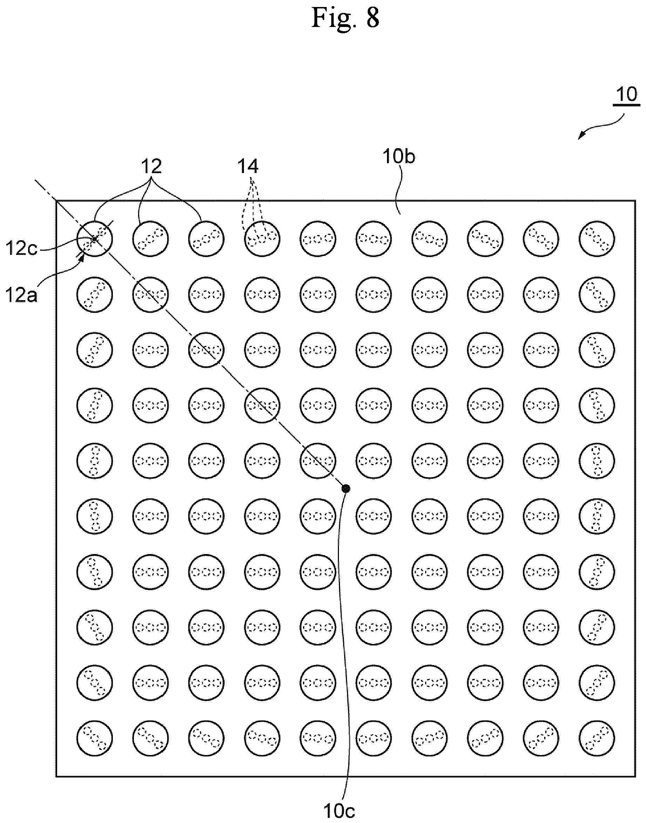

Next, using FIG. 1A and FIG. 1C, a ceramic substrate 10 according to Embodiment 2 of the disclosure will be described with reference to FIG. 8. FIG. 8 is a bottom view of the ceramic substrate 10 of the embodiment correspond to FIG. 1B.

Similarly to the above-described ceramic substrate 10 according to Embodiment 1, the ceramic substrate 10 of the embodiment includes a plurality of electrodes 12 arranged at predetermined intervals in each of the third direction and the fourth direction that are parallel to the surface 10b and mutually orthogonal. The ceramic substrate 10 of the embodiment includes a plurality of vias 14 on a center portion 12a in the first direction of each electrode 12 along the second direction of each electrode 12 in at least an outer circumference along the outer edge of the surface 10b.

That is, in the ceramic substrate 10 of the embodiment, the plurality of electrodes 12 are disposed on, for example, the intersection points of the plurality of straight lines parallel to the third direction along the longitudinal outer edge of the ceramic substrate 10 and the plurality of straight lines parallel to the fourth direction along the lateral outer edge of the ceramic substrate 10. In addition, only the electrodes 12 arranged along the outer edge of the ceramic substrate 10 are provided with the plurality of vias 14 on the center portions 12a in the first directions of the respective electrodes 12 along the second directions of the respective electrodes 12. For the electrodes 12 disposed on the center 10c side of the ceramic substrate 10 with respect to those electrodes 12, for example, the plurality of vias 14 are arranged along the lateral outer edge of the ceramic substrate 10. The other configuration of the ceramic substrate 10 of the embodiment is similar to that of the above-described ceramic substrate 10 of Embodiment 1.

The ceramic substrate 10 of the embodiment can provide the effect similar to that of the above-described ceramic substrate 10 of Embodiment 1 on the outer circumference of the ceramic substrate 10 where the thermal stress acting on the electrode 12 is maximum. In a region inside the outer circumference where the thermal stress acting on the electrode 12 is small compared with the outer circumference of the ceramic substrate 10, the plurality of vias 14 connected to each electrode 12 can be uniformly arranged.

This ensures, for example, a simplified mask pattern in a process of forming the through holes 15h in the ceramic green sheet 15g and disposing the paste material containing silver on the through holes 15h to form the vias 14 and the inner layer vias 14i. Accordingly, the manufacture of the mask can be facilitated. The arrangement of the plurality of vias 14 connected to each electrode 12 in the portion inside the outer circumference of the ceramic substrate 10 is not necessary uniform for all the electrodes 12. For example, considering routing of wiring and the like, the plurality of vias 14 of each electrode 12 may be arranged in any direction.

### (Embodiment 3)

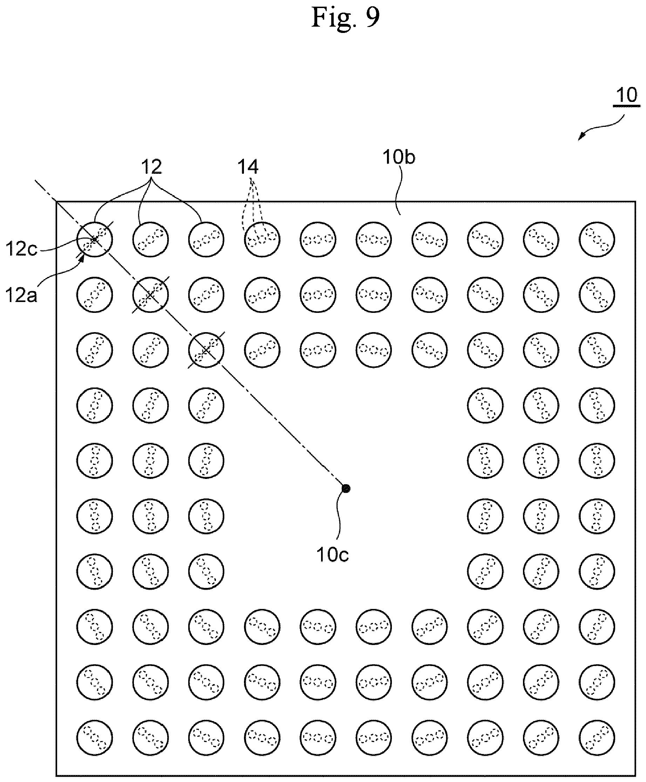

Next, using FIG. 1A and FIG. 1C, a ceramic substrate 10 according to Embodiment 3 of the disclosure will be described with reference to FIG. 9. FIG. 9 is a bottom view of the ceramic substrate 10 of the embodiment correspond to FIG. 1B.

The ceramic substrate 10 of the embodiment is different from the ceramic substrate 10 of Embodiment 1 illustrated in FIG. 1B in that the electrode 12 is not disposed at the proximity of the center 10c of the surface 10b. The other configuration of the ceramic substrate 10 of the embodiment is similar to that of the above-described ceramic substrate 10 of Embodiment 1. The ceramic substrate 10 of the embodiment also can provide the effect similar to that of the above-described ceramic substrate 10 of Embodiment 1.

### (Embodiment 4)

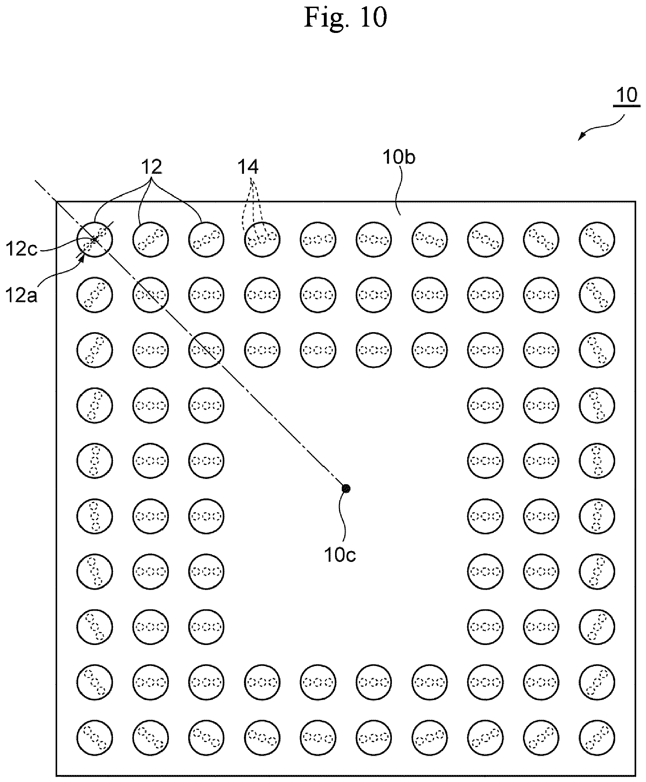

Next, using FIG. 1A and FIG. 1C, a ceramic substrate 10 according to Embodiment 4 of the disclosure will be described with reference to FIG. 10. FIG. 10 is a bottom view of the ceramic substrate 10 of the embodiment correspond to FIG. 1B.

The ceramic substrate 10 of the embodiment is different from the ceramic substrate 10 of Embodiment 2 illustrated in FIG. 8 in that the electrode 12 is not disposed at the proximity of the center 10c of the surface 10b. The other configuration of the ceramic substrate 10 of the embodiment is similar to that of the above-described ceramic substrate 10 of Embodiment 2. The ceramic substrate 10 of the embodiment also can provide the effect similar to that of the above-described ceramic substrate 10 of Embodiment 2.

### (Embodiment 5)

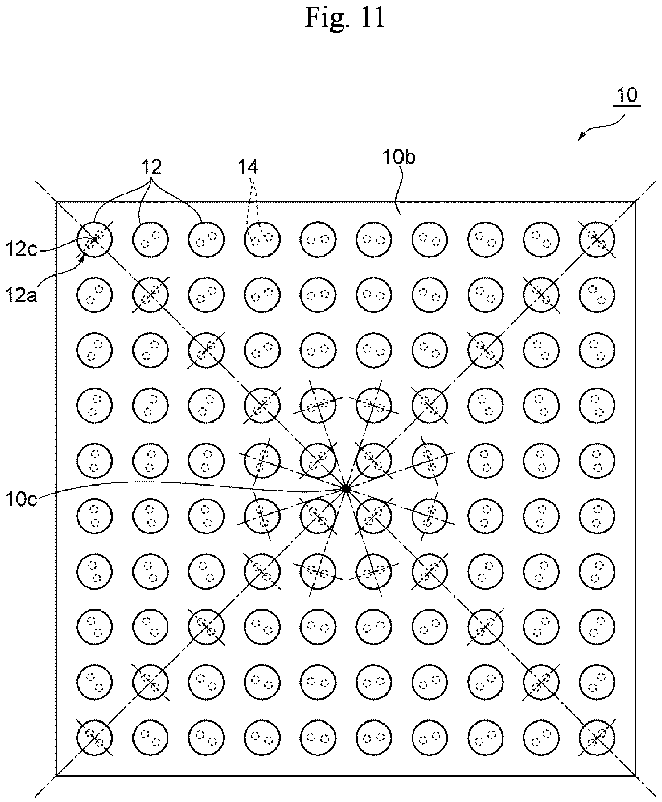

Next, using FIG. 1A and FIG. 1C, a ceramic substrate 10 according to Embodiment 5 of the disclosure will be described with reference to FIG. 11. FIG. 11 is a bottom view of the ceramic substrate 10 of the embodiment correspond to FIG. 1B.

The ceramic substrate 10 of the embodiment is different from the ceramic substrate 10 of Embodiment 1 illustrated in FIG. 1B in that the electrodes 12 are each connected to the two vias 14. The other configuration of the ceramic substrate 10 of the embodiment is similar to that of the above-described ceramic substrate 10 of Embodiment 1. It is not necessary that all the electrodes 12 are connected to the same number of the vias 14, and the number of the vias 14 connected to each of the electrodes 12 may be changed as necessary. The ceramic substrate 10 of the embodiment also can provide the effect similar to that of the above-described ceramic substrate 10 of Embodiment 1.

### (Embodiment 6)

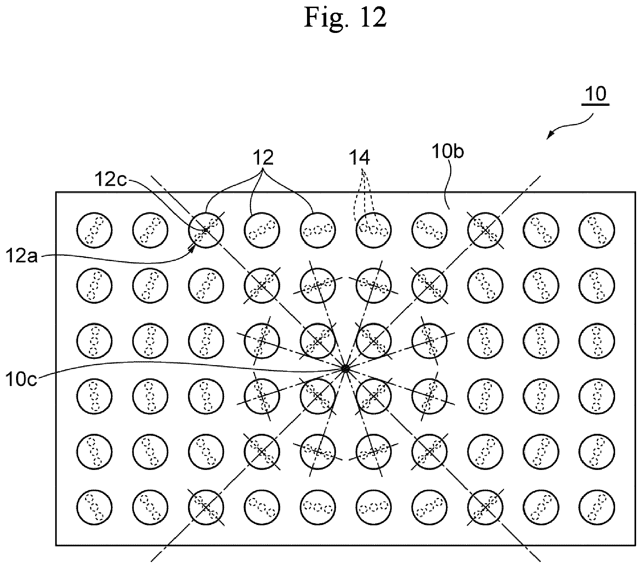

Next, using FIG. 1A and FIG. 1C, a ceramic substrate 10 according to Embodiment 6 of the disclosure will be described with reference to FIG. 12. FIG. 12 is a bottom view of the ceramic substrate 10 of the embodiment correspond to FIG. 1B.

The ceramic substrate 10 of the embodiment is different from the ceramic substrate 10 of Embodiment 1 illustrated in FIG. 1B in that the planar shape is rectangular. The other configuration of the ceramic substrate 10 of the embodiment is similar to that of the above-described ceramic substrate 10 of Embodiment 1. The ceramic substrate 10 of the embodiment also can provide the effect similar to that of the above-described ceramic substrate 10 of Embodiment 1.

### (Embodiment 7)

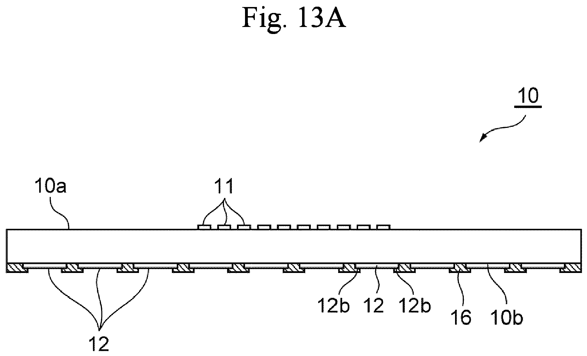

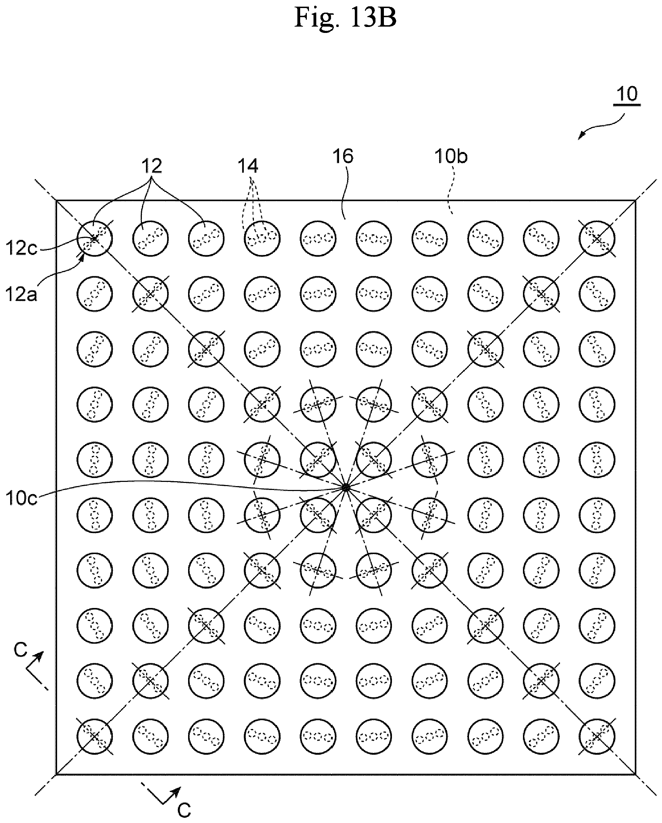

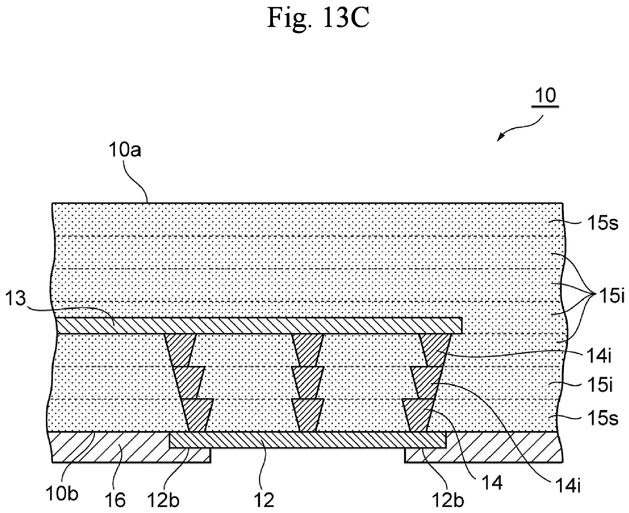

Next, a ceramic substrate 10 according to Embodiment 7 of the disclosure will be described with reference to FIG. 13A to FIG. 13C. FIG. 13A is a cross-sectional view of the ceramic substrate 10 of the embodiment. FIG. 13B is a bottom view of the ceramic substrate 10 illustrated in FIG. 13A. FIG. 13C is an enlarged cross-sectional view taken along the line C-C of the ceramic substrate 10 illustrated in FIG. 13B.

The ceramic substrate 10 of the embodiment is different from the above-described ceramic substrate 10 of Embodiment 1 in that a resist layer 16 is disposed to cover the surface 10b including a peripheral edge portion 12b of the electrode 12, and a part of the plurality of vias 14 is connected to the peripheral edge portion 12b of the electrode 12. For the resist layer 16, for example, a solder resist material having low wettability to solder can be used.

With this configuration, in the ceramic substrate 10 of the embodiment, the peripheral edge portions 12b of the respective electrodes 12 are covered with the resist layer 16, and the peripheral edge portions 12b are not exposed on the surface 10b. This ensures suppressing the connection of the solder balls 40 illustrated in FIG. 2A to the peripheral edge portions 12b of the electrodes 12. Accordingly, after mounting the ceramic substrate 10 to the mounting board 30, the thermal stress acting on the peripheral edge portion 12b of the electrode 12 due to the temperature change of the ceramic substrate 10 and the mounting board 30 is reduced. Furthermore, covering the peripheral edge portion 12b of the electrode 12 with the resist layer 16 ensures more effectively suppressing peeling of the peripheral edge portion 12b of the electrode 12 off the surface 10b.

Furthermore, a part of the plurality of vias 14 connected to each of the electrodes 12 is connected to the peripheral edge portion 12b of the electrode 12 covered with the resist layer 16. With this configuration, the thermal stress acting between the peripheral edge portion 12b of the electrode 12 and the via 14 connected to the peripheral edge portion 12b can be more effectively reduced by the resist layer 16. Accordingly, the ceramic substrate 10 of the embodiment can not only provide the effect similar to that of the ceramic substrate 10 of Embodiment 1, but also provide the reliability more improved by the resist layer 16.

As a modification of the ceramic substrate 10 of the embodiment, the peripheral edge portion 12b of the electrode 12 may be covered with a material having the same composition as the material of the ceramic substrate 10 instead of the resist layer 16. In this case, instead of the resist layer 16, for example, a material to form a ceramic layer is printed on the surface of the ceramic substrate 10 on which the electrode 12 is formed to cover the surface of the ceramic substrate 10 including the peripheral edge portion 12b of the electrode 12. Subsequently, the material to form the ceramic layer is sintered to strongly connect the formed ceramic layer to the ceramic substrate 10. This ensures the improved reliability of the ceramic substrate 10.

While the embodiments of the ceramic substrate according to the disclosure have been described in detail using the drawings, the specific configuration is not limited to the embodiments. Design changes and the like within a scope not departing from the gist of the disclosure are included in the disclosure.

### [Example]

The following describes the example of the ceramic substrate according to the disclosure.

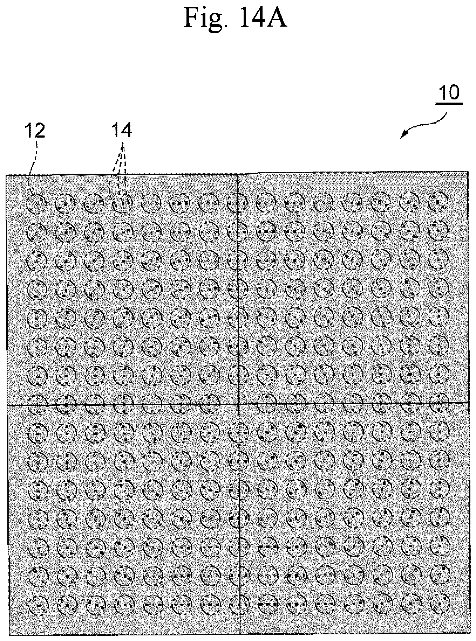

FIG. 14A is a bottom view illustrating an analytical model of the ceramic substrate 10 of the example. First, computer software was used to form the analytical model where the plurality of vias 14 were arranged on each electrode 12 similarly to the above-described ceramic substrate 10 of Embodiment 1.

In the analytical model, 15 electrodes 12 were each disposed longitudinally and laterally with the pitch (distance between centers) of 1.2 [mm], that is, 225 electrodes 12 in total were disposed in an array of 15 × 15 longitudinally and laterally. Three vias 14 were connected to each electrode 12. The ceramic substrate 10 was formed having the dimensions of length × width × thickness as 20 [mm] × 20 [mm] × 1 [mm]. The electrode 12 was formed in a circular shape having the diameter of 0.8 [mm]. The via 14 was formed in a columnar shape having the diameter of 0.08 [mm]. The pitch of the vias 14 on each electrode 12 was 0.5 [mm].

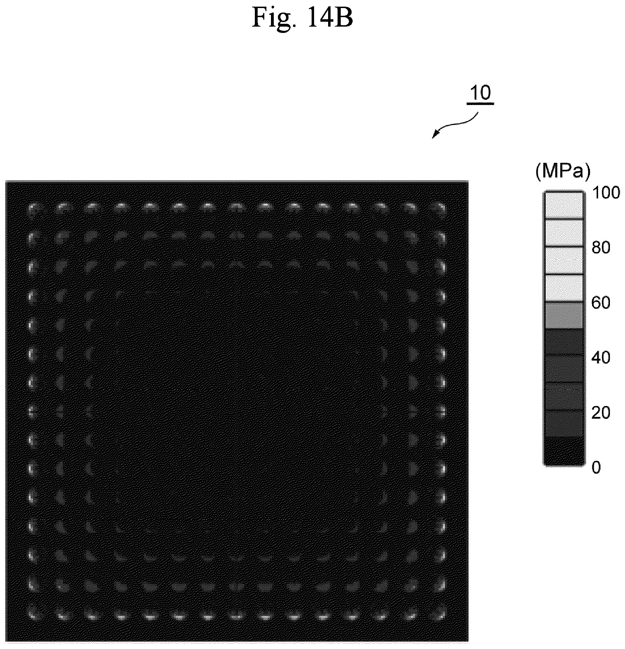

Next, an analytical model was formed such that the analytical model of the ceramic substrate 10 of the example formed as described above was mounted to an analytical model of the mounting board having the thickness of 1.6 [mm] via the solder balls. The thermal stress acting on each electrode when the temperatures of the ceramic substrate 10 and the mounting board were lowered was calculated by a finite element method. FIG. 14B indicates a principal stress distribution as the calculation result of the thermal stress.

As illustrated in FIG. 14B, the closer to the outer edge of the ceramic substrate 10 the electrode 12 is disposed, the higher the thermal stress acting on the plurality of electrodes 12 of the ceramic substrate 10 becomes. The closer to the outer edge of the ceramic substrate 10 the part is disposed, the higher the thermal stress acting on each electrode 12 also becomes. While the illustration is omitted, also in the case where the same analytical model is used and the temperatures of the ceramic substrate 10 and the mounting board are raised, the closer to the outer edge of the ceramic substrate 10 the electrode 12 is disposed, the higher the thermal stress acting on the plurality of electrodes 12 becomes. Meanwhile, the closer to the center of the surface, on which the electrodes 12 are disposed, of the ceramic substrate 10 the part is disposed, the higher the thermal stress acting on each of the electrodes 12 becomes.

In the analytical model of the ceramic substrate 10 of the example, the plurality of vias 14 are provided on the center portion in the first direction of the electrode 12 along the second direction. The first direction is parallel to the surface on which the electrode 12 is disposed, and is a direction connecting the center of the surface to the center of the electrode 12. The second direction is parallel to the surface and perpendicular to the first direction. As a result, for each electrode 12, the maximum thermal stress acting on the center portion on which the vias 14 were provided was 75.1 [MPa], which is smaller than the maximum thermal stress acting on the other portion.

### [Comparative Example]

Next, a description will be given of a comparative example having a configuration different from that of the ceramic substrate according to the disclosure.

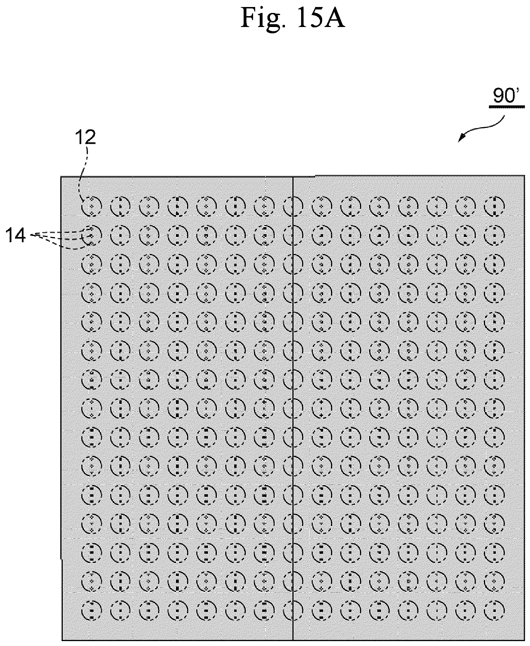

FIG. 15A is a bottom view illustrating an analytical model of the ceramic substrate of the comparative example. First, computer software was used to form the analytical model of a ceramic substrate 90' of the comparative example where the arrangement of the plurality of vias connected to each electrode was changed for the ceramic substrate 10 of the example. More specifically, for all the electrodes 12, the plurality of vias 14 were arranged along longitudinal side edges of the rectangular ceramic substrate 90'.

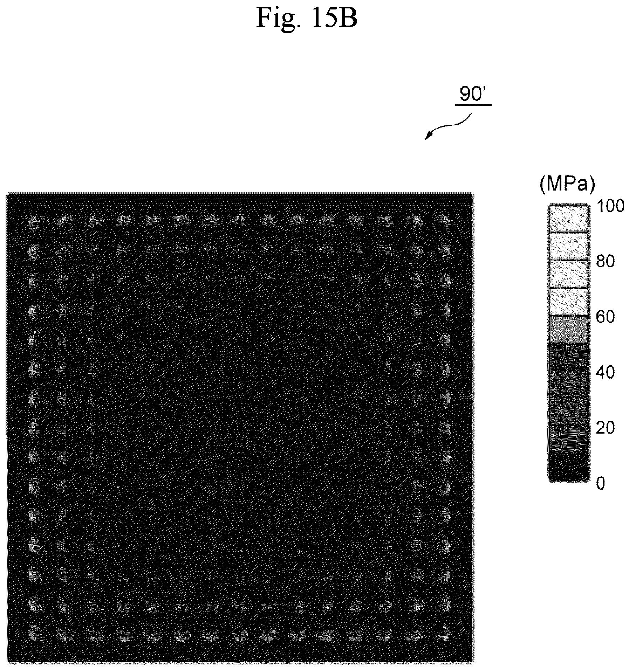

Next, an analytical model was formed such that the analytical model of the ceramic substrate 90' of the comparative example formed as described above was mounted to an analytical model of the mounting board having the thickness of 1.6 [mm] via the solder balls. The thermal stress acting on each electrode 12 when the temperatures of the ceramic substrate 90' and the mounting board were lowered was calculated by a finite element method. FIG. 15B indicates a principal stress distribution as the calculation result of the thermal stress.

In the analytical model of the ceramic substrate 90' of the comparative example, for all the electrodes 12, the plurality of vias 14 were arranged along the longitudinal side edges of the rectangular ceramic substrate 90'. As a result, for each electrode 12, the maximum thermal stress acting on the vias 14 was increased to 97.9 [MPa] compared with the analytical model of the ceramic substrate 10 of the example.

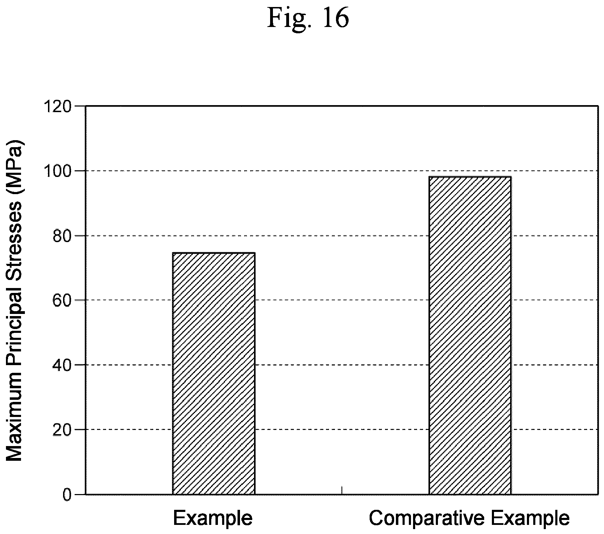

FIG. 16 indicates a graph comparing the analysis result of the ceramic substrate 10 of the example with the analysis result of the ceramic substrate 90' of the comparative example. As illustrated in FIG. 16, the maximum principal stress acting on the vias 14 of the ceramic substrate 10 of the example was decreased to about 3/4 of the maximum principal stress acting on the vias 14 of the ceramic substrate 90' of the comparative example. From the above-described results, the ceramic substrate 10 of the example can reduce the thermal stress acting on the vias 14 to suppress the reduced reliability caused by the thermal stress compared with the ceramic substrate 90' of the comparative example.

### DESCRIPTION OF SYMBOLS

- 10: Ceramic substrate
- 10a: Surface
- 10b: Surface
- 10c: Center
- 11: Primary side electrode
- 12: Electrode (secondary side electrode)
- 12a: Center portion
- 12b: Peripheral edge portion
- 12c: Center
- 13: Inner layer wiring
- 14: Via
- 14i: Inner layer via
- 15g: Ceramic green sheet
- 15h: Through hole
- 15i: Ceramic layer
- 15s: Ceramic layer
- 16: Resist layer
- 20: Semiconductor element
- 30: Mounting board
- 40: Solder ball
- 41: Thin solder layer
- 50: Solder ball

## Claims

1. A ceramic substrate comprising:
an electrode; and
a via (14) connected to the electrode,
wherein a plurality of the vias (14) are provided to a center portion in a first direction of the electrode along a second direction, the first direction is parallel to a surface on which the electrode (12) is disposed, the first direction is a direction connecting a center of the surface to a center of the electrode, and the second direction is parallel to the surface and perpendicular to the first direction.

2. The ceramic substrate according to claim 1,
wherein the ceramic substrate (10) includes a plurality of the electrodes on the surface, and
wherein the plurality of vias (14) are provided to the center portion in the first direction of each of the electrodes along the second direction of each of the electrodes.

3. The ceramic substrate according to claim 1,
wherein the ceramic substrate (10) includes a plurality of the electrodes disposed at predetermined intervals in each of a third direction and a fourth direction, and the third direction and the fourth direction are parallel to the surface and mutually orthogonal, and
wherein on at least an outer circumference along an outer edge of the surface, the plurality of vias (14) are provided to the center portion in the first direction of each of the electrodes along the second direction of each of the electrodes.

4. The ceramic substrate according to claim 3,
wherein the plurality of electrodes are disposed on intersection points of a plurality of straight lines parallel to the third direction and a plurality of straight lines parallel to the fourth direction.

5. The ceramic substrate according to claim 1,
wherein the ceramic substrate (10) has a multilayer structure in which a plurality of ceramic layers are laminated,
wherein a plurality of inner layer vias (14i) are provided to the ceramic layer inside the ceramic layer on the surface side on which the via is provided, and
wherein the plurality of inner layer vias are provided in the second direction at intervals different from intervals of the vias on the surface side, and at least partially connected to the vias on the surface side.

6. The ceramic substrate according to claim 5, further comprising
a plurality of primary side electrodes (11) on a surface on an opposite side of the surface, the plurality of primary side electrodes (11) being connected to a semiconductor element (20),
wherein a plurality of the electrodes are disposed in a wide range compared with the plurality of primary side electrodes (11), and the plurality of electrodes are secondary side electrodes (12) connected to a mounting board (30), and
wherein the primary side electrodes (11) are connected to the respective secondary side electrodes (12) via at least a part of the plurality of vias (14) and at least a part of the plurality of inner layer vias (14i).

7. The ceramic substrate according to claim 1, further comprising
a resist layer that covers the surface including a peripheral edge portion of the electrode,
wherein a part of the plurality of vias (14) is connected to the peripheral edge portion.
